# EUROPÄISCHE PATENTSCHRIFT

(11) **EP 1 775 413 B1**
(45) Veröffentlichungstag und Bekanntmachung des Hinweises auf die Patenterteilung: **24.02.2010**
(21) Anmeldenummer: 06122036.4
(22) Anmeldetag: 10.10.2006
(51) Int. Cl.: E06B 5/18, H05K 9/00, E06B 7/23

(54) **Pneumatische Dichtung für Türen oder Tore sowie Tür oder Tor mit einer solchen Dichtung zum Schutz gegen elektromagnetische Impulse**
Pneumatic sealing for doors or gates and door or gate with such a sealing for protection against electromagnetic pulse
Joint d'étanchéité pneumatique pour portes et porte avec un pareil joint contre impulsion électromagnétique

(30) Priorität: 11.10.2005 DE 102005048701
(43) Veröffentlichungstag der Anmeldung: 18.04.2007
(73) Patentinhaber: Sommer Metallbau-Stahlbau GmbH & Co. KG, 95182 Döhlau (DE)
(72) Erfinder: Hautmann, Dieter, 95126 Schwarzenbach (DE); Hofmann, Jürgen, 92182 Tauperlitz (DE); Sommer, Oliver, 92028 Hof/Saale (DE)
(74) Vertreter: Skuhra, Udo

(56) Entgegenhaltungen:
- EP-A- 0 265 676
- DE-A1- 3 827 608
- DE-C- 591 273
- US-A- 2 932 862
- US-A- 3 507 974
- US-A- 4 441 278
- US-A- 4 525 595
- US-A- 6 116 615

## Beschreibung

Die Erfindung betrifft eine pneumatische Dichtung für Türen oder Tore, insbesondere Dreh- oder Schiebetore und Drehtüren sowie eine Tür oder Tor zum Verschließen einer Gebäudeöffnung.

In der US-A 3,507,974 ist eine Türkonstruktion mit elektromagnetischer Abschirmung beschrieben, die seitlich am Falz vorgesehene paarweise aufblähbare Dichtungen aufweist, die in einen nutförmigen Körper eingesetzt sind. Beide Dichtungen werden durch ein Kontaktelement teilweise übergriffen, welches in Anlage zu einer Anschlagleiste gelangt, wenn die Dichtung aufgeblasen ist.

Die DE 38 27 608 A1 beschreibt eine Vorrichtung zum Abdichten von Türen und Luken mit einem Dichtungsschlauch, der in Aktivstellung eine elektronische Verbindung zwischen Zarge und Türblatt und damit einen HF-sicheren Türverschluss bildet.

In der US-A 4,525,595 ist eine stumpf angeschlagene Tür beschrieben, bei der Kontaktfedern vollständig über eine aufblähbare Dichtung verlaufen, wodurch ein luftdichter Zustand nicht gewährleistet wird. Darüber hinaus steht die Dichtung nicht direkt in Kontakt mit einem gebäudeseitigen Einbaurahmen.

Verschiedene Gebäude, z.B. auch Krankenhäuser müssen vor elektromagnetischen Impulsen (EMP, Electromagnetic Pulse) geschützt werden, um Apparaturen gegenüber einer Beeinflussung von außen abzuschirmen.

Bei einem elektromagnetischen Impuls handelt es sich um eine sehr kurze, aber äußerst starke elektromagnetische Welle. Durch die induzierten Ströme in elektrisch leitfähigem Material können elektrische und elektronische Einrichtungen zerstört werden. Solche starken elektromagnetischen Impulse können beispielsweise durch Blitze oder Atombomben erzeugt werden.

Bei der Explosion einer Atombombe entsteht durch die Spalt- und Zerfallprozesse Gammastrahlung. Die Gammastrahlung wirkt auf die sie umgebenden Moleküle und Atome durch den Comptoneffekt. Durch den Comptoneffekt freigesetzte Elektronen bewegen sich mit hoher Geschwindigkeit vom Zentrum der Explosion weg, während sich die ionisierten Atome nur langsam bewegen können. Durch diese Ladungstrennung wird kurzzeitig ein starkes elektromagnetisches Feld aufgebaut. Dieses bricht schnell wieder in sich zusammen, da sich die positiv geladenen Ionen und Elektronen im Feld wieder aufeinander zu bewegen.

Das starke elektromagnetische Feld existiert zwar nur sehr kurz, die Auswirkungen können aber gravierend sein. Gerade weil das Feld derart schnell wieder in sich zusammenfällt, können hohe Spannungen in elektrisch leitfähigen Materialien entstehen. Da sich die Felder mit Lichtgeschwindigkeit ausbreiten, ist auch keine Warnung möglicherweise betroffener Gebiete möglich. Die entstehenden Spannungen und Ströme zerstören elektrische Geräte wie Transformatoren, Telefonleitungen, Computer oder dergleichen, sofern sie nicht entsprechend abgeschirmt sind.

In Abhängigkeit von der Ursache oder der Stärke des erzeugten elektromagnetischen Impulses wird zwischen LEMP (Lightning Electromagnetic Impulse), HEMP (High Electromagnetic Impulse) und NEMP (Nuclear Electromagnetic Impulse) differenziert.

LEMP-Schutzmaßnahmen sind in DIN V V DI V 0185 Teil 4 und HEMP-Schutzmaßnahmen sind in DIN EN 61000-2-9 standardisiert.

Zum Schutz von Gebäuden oder Räumen gegen hochfrequente elektromagnetische Impulse werden Gebäude mit einem elektrisch leitenden Gewebe versehen, das eine Maschenweite je nach den Anforderungen besitzt. Problematisch sind jedoch die Eingangsbereiche, d.h. die Tür- und Torbereiche, da diese bei geschlossener Tür bzw. geschlossenem Tor ebenfalls eine Abschirmung gegenüber elektromagnetischen Impulsen gewährleisten sollen.

Der Erfindung liegt daher die Aufgabe zugrunde, eine pneumatische Dichtung für Türen oder Tore sowie eine Tür oder ein Tor zu schaffen, welche gegenüber einer Gebäudeöffnung einen sicheren Schutz gegenüber hochfrequenten elektromagnetischen Impulsen und/oder elektromagnetischen Feldern sowie einem luftdichten Verschluss ermöglichen.

Diese Aufgabe wird erfindungsgemäß durch die im Patentanspruch 1 genannten Merkmale gelöst.

Weitere Ausgestaltungen der Erfindung ergeben sich aus den Unteransprüchen.

Die nachfolgend in Bezug auf eine Tür bzw. ein Tor beschriebene Anordnung lässt sich im Prinzip bei Drehtüren, Schiebetoren und Drehtoren einsetzen. Erfindungsgemäß ist eine Abschirmung gegenüber hochfrequenten elektromagnetischen Impulsen dadurch sichergestellt, dass im Bereich einer pneumatisch wirksamen Dichtung Federelemente vorgesehen sind, die zum Einen elektrisch gut leitend mit der Tür- bzw. Torplatte verbunden sind und zum Anderen aufgrund der Wirkung der pneumatischen Dichtung bei geschlossener Tür bzw. bei geschlossenem Tor gegen den gebäudeseitig angebrachten, elektrisch leitenden Einbaurahmen gedrückt werden.

Im Folgenden werden bevorzugte Ausführungsformen des erfindungsgemäßen Tores anhand der Zeichnung zur Erläuterung weiterer Merkmale beschrieben. Es zeigen:
Fig. 1 eine schematische Darstellung einer bekannten Anordnung mit elektrisch leitenden Kontaktfedern,
Fig. 2 eine schematische Darstellung eines Tores gegenüber einer Gebäudeöffnung gemäß der Erfindung,
Fig. 3 eine Detaildarstellung der erfindungsgemäßen Anordnung der pneumatischen Dichtung in Bezug auf eine Drehtür,
Fig. 4 eine Teildarstellung der erfindungsgemäßen Anordnung der Dichtung nach einer weiteren Ausführungsform, insbesondere zum Einsatz bei einem Schiebetor,
Fig. 5 eine Darstellung der erfindungsgemäßen Dichtungsanordnung gemäß einer weiteren Ausführungsform, insbesondere zur Verwendung bei einem Drehtor, und
Fig. 6 a, b, c Perspektivansichten von bevorzugten Ausführungsformen von Federkontaktelementen.

Nachfolgend werden verschiedene Ausführungsformen eines erfindungsgemäßen Tores mit pneumatischer Dichtung mit integrierter Abschirmung gegenüber elektromagnetischer Strahlung beschrieben, wobei vorzugsweise eine Abschirmung im Bereich von 3 MHz bis 3 GHz erwünscht ist.

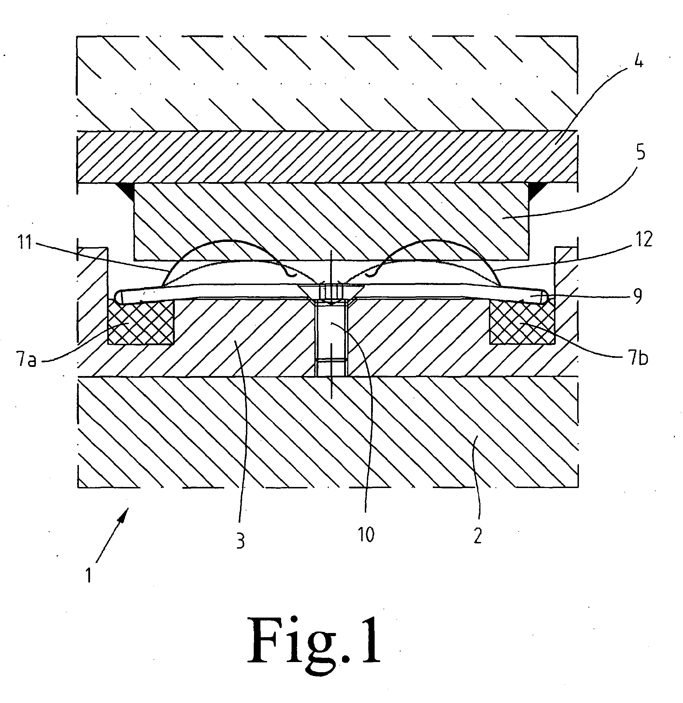

Fig. 1 zeigt eine an sich bekannte Anordnung an einem Drehtor zur Abschirmung gegenüber elektromagnetischen Impulsen. Die in Fig. 1 gezeigte Anordnung ist umlaufend an einem Drehtor vorgesehen und zur Anlage an einem gebäudeseitig eingesetzten Einbaurahmen aus Metall bzw. Stahl vorgesehen. Nach der bekannten Anordnung ist an dem mit 1 bezeichneten Tor auf der zur Gebäudeöffnung weisenden Seite einer Torkonstruktion 2 mit einer Platte oder Leiste 3 vorgesehen, die nahe den Seitenkanten des Tores vorzugsweise vollständig umlaufend ausgebildet ist und am Tor 1 an derjenigen Position angebracht ist, die im geschlossenen Zustand des Tores dem gebäudeseitigen Einbaurahmen 4 gegenüberliegt.

Am Einbaurahmen 4 ist eine entsprechende horizontal und/oder vertikal verlaufende Anschlagleiste 5 angebracht. Hierbei sind in der Leiste 3 zwei zueinander parallele Kanäle 7a, 7b vorgesehen. In diesen Kanälen oder Nuten 7a, 7b befinden sich elektrisch leitfähige Gewebestricke 8a, 8b, die mittels einer vorgespannten Feder 9 elektrisch kontaktiert werden, wobei die Feder 9 durch Schrauben 10 oder dergleichen an der Leiste 3 befestigt ist. Die Feder 9 kann in Form einer Federleiste vorgesehen sein, die sich über die gesamte Länge des Tores erstreckt. Durch die Schraubmittel 10 werden eine oder mehrere Kontaktfedern 11, 12 gegenüber der Leiste 3 fixiert und bewirken bei geschlossenem Tor einen elektrischen Kontakt zwischen der Leiste 3 einerseits und der Anschlagleiste 5 gebäudeseitig andererseits. Mit dieser Anordnung kann zwar eine elektrische Abschirmung der Gebäudeöffnung über das Tor erreicht werden. Es wird jedoch kein luftdichter Verschluss zwischen Tor und gebäudeseitigem Einbaurahmen hergestellt.

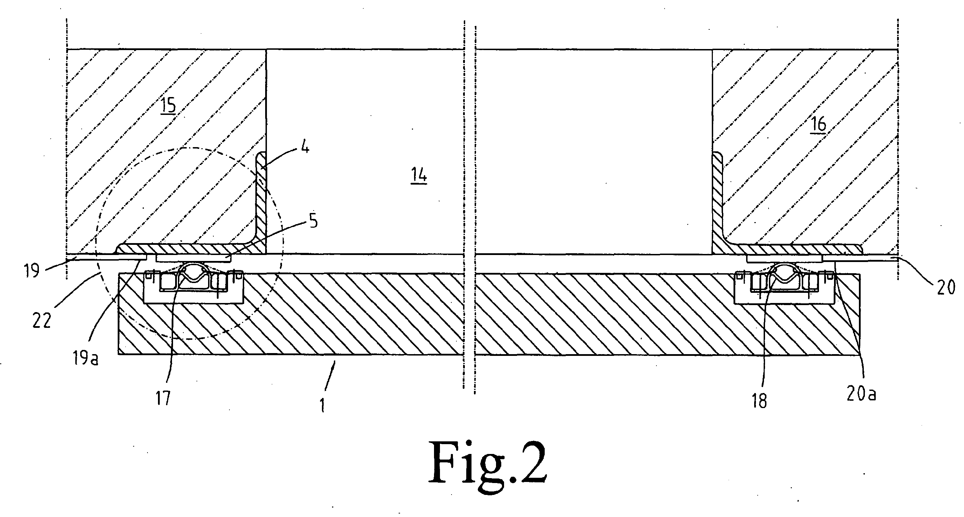

Fig. 2 zeigt eine schematische Anordnung zur Darstellung eines Tores mit pneumatischer Dichtung gegenüber einer Gebäudeöffnung 14. Die seitlich der Gebäudeöffnung 14 dargestellten Gebäudewandungen sind mit 15 und 16 bezeichnet. Aus Fig. 2 ist ersichtlich, dass das Tor 1 dem auf beiden Seiten der Gebäudeöffnung 14 angeordneten Einbaurahmen 4 zugeordnete pneumatische Dichtungselemente 17, 18 aufweist. Diese Dichtungselemente 17, 18 sind vertikal und horizontal an der oberen und unteren Seite des Tores vorgesehen bei entsprechendem Einbaurahmen in der Gebäudeöffnung, d.h., wenn die Einbaurahmen der Gebäudeöffnung 14 zusätzlich zu den vertikalen Abschnitten oben und unten horizontal verlaufend ausgebildet sind. Ersichtlicherweise wird ein vollständig umlaufendes pneumatisches Dichtungselement 17, 18 im Torbereich bevorzugt.

Wie sich aus Fig. 2 weiter ergibt, ist die Gebäudeaußenfläche mit einem elektrisch leitfähigen Gewebe 19, 20 ausgerüstet, welches über ein beispielsweise querstehendes Ende 19a, 20a mit den gebäudeseitigen Einbaurahmen in Berührung bzw. elektrischem Kontakt steht.

Nachfolgend werden Einzelheiten des in Fig. 2 mit 22 bezeichneten Bereichs näher erläutert.

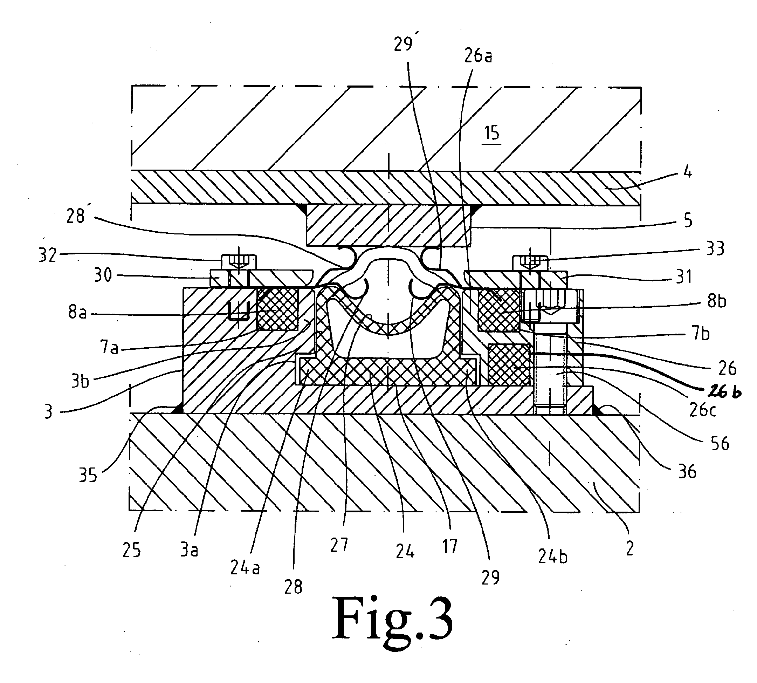

Fig. 3 zeigt eine bevorzugte Ausführungsform einer Anordnung der Dichtung im Torbereich. Das dort dargestellte Dichtungselement 17 weist eine Basis 24 auf, die fest in die Türkonstruktion 2 integriert ist. Bei der dargestellten Ausführungsform ist auf der Türkonstruktion 2 eine Leiste 3 vorgesehen, die profiliert ist und an das Profil des Dichtungselements 17 angepasst ist. Bei der dargestellten Ausführungsform besitzt die Basis 24 Sockel- oder Fußabschnitte 24a, 24b, die über den eigentlichen Dichtungskörper 25 seitlich abstehen, wobei der Dichtungskörper 25 einen schlauchähnlichen Dichtungskörper darstellt. Eine entsprechende Nut 3a in der Leiste 3 nimmt in Fig. 3 den linken Sockel 24 auf. Die Leiste 3 ist an der Türkonstruktion 2 angebracht, vorzugsweise angeschweißt. Auf der in Fig. 3 rechten Seite wird das Dichtungselement 17 verklotzt, indem der Sockel 24b durch eine schmale Klemmleiste 26 erfasst wird, wobei die Klemmleiste 26 durch Schraubmittel 56 oder dergleichen an der Leiste 3 befestigt werden kann. Damit sitzt das Dichtungselement 17 fest innerhalb der Leiste 3 und wird in Fig. 3 seitlich nach rechts durch die Klemmleiste 26 abgeschlossen bzw. eingefasst. Das aufblasbare Dichtungselement 17 sitzt im nicht-aktivierten Zustand innerhalb der Leiste 3, wie aus Fig. 3 hervorgeht und wird an ihrer Dichtungsoberfläche 27 von vorzugsweise zwei Kontaktfedern 28, 29 überlappt. Die Kontaktfedern 28, 29 weisen ein hakenförmiges und/oder kreisbogenförmiges Ende auf, wie in Fig. 3 dargestellt, wobei sich dieses Federende von der Leiste 3 bzw. Klemmleiste 26 her in Richtung auf die Mitte bzw. Achse des Dichtungselements 17 erstreckt, derart, dass nach dem Aufblasen des Dichtungselements 17 die Enden durch die Dichtungsoberfläche 27 in Richtung auf den Einbaurahmen 4 verlagert und gegen die am Einbaurahmen 4 angebrachte Anschlagleiste 5 angedrückt werden, wie dies durch die Bezugsziffern 28' und 29' gezeigt ist. Ein Ende der Kontaktfedern 28, 29 sitzt in einem elektrisch leitfähigen Gewebe bzw. Gewebestrick 8a, 8b, der in die Nuten 7a, 7b eingesetzt ist und elektrisch leitend ist. Auf diese Weise wird ein guter elektrischer Kontaktschluss zwischen der Leiste 3 bzw. Klemmleiste 26, den Gewebestricken 8a, 8b und den Kontaktfedern 28, 29 gewährleistet und damit auch ein elektrischer Kontakt gegenüber der Anschlagleiste 5 bzw. dem Einbaurahmen 4 gebäudeseitig.

Die Kontaktfedern 28, 29 sind einzelne Federelemente, jedoch vorzugsweise Federstreifen, die vorzugsweise im Bereich der Gewebestricke 8a, 8b einen durchgängigen Abschnitt, d.h. einen Streifen ohne Unterbrechung bilden, während im Bereich der haken- oder kreisförmigen federenden Schlitzungen vorgesehen sein können, wobei die Schlitzbreite bei etwa 1 mm liegt.

Zur Befestigung der in das Gewebe 8a, 8b eingesetzten Kontaktfederenden dienen Klemmleisten 30, 31, welche mit Schraubmitteln 32, 33 oder dergleichen an der Leiste 3 bzw. Klemmleiste 26 befestigt sind. Wie sich aus Fig. 3 ergibt, werden vorbestimmte Abschnitte der Kontaktfedern 28, 29 durch diese Klemmleisten 30, 31 klemmend gegenüber dem Gewebe 8a, 8b und auch gegenüber Abschnitten 3b, 26a eingeklemmt, so dass eine feste Halterung der Kontaktfedern 28, 29 gewährleistet ist.

Um einen guten elektrischen Kontakt zwischen der Leiste 3 und der Klemmleiste 26 zu erreichen, ist an der Unterseite der Klemmleiste 26 eine Nut 26b ausgebildet, in die ein elektrisch leitfähiges Gewebe, vorzugsweise ein Gewebestrick 8a, 8b eingesetzt ist, der einen guten elektrischen Kontakt zwischen der Leiste 3 einerseits und der Klemmleiste 26 andererseits gewährleistet. Der Aufbau der sich in Fig. 3 nach unten, d.h. der vom Tor sich an die Leiste 3 nach außen anschließenden Türkonstruktion 2 ist abhängig von den jeweiligen Vorgaben und wird hier nicht weiter erläutert.

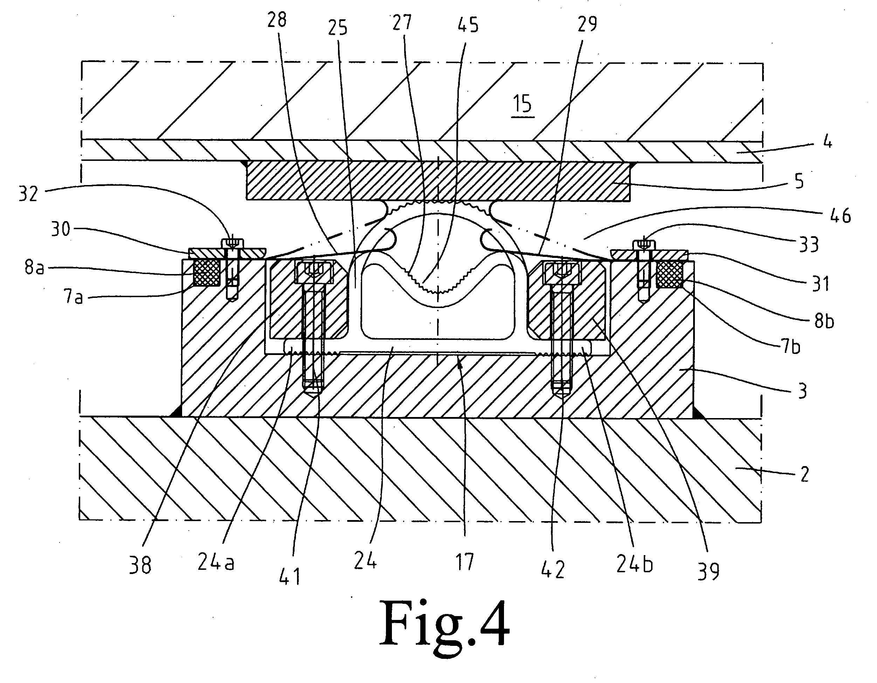

Die in Fig. 3 dargestellte Ausführungsform betrifft eine Drehtür mit aufblasbarem Dichtungselement 17, wobei das in Fig. 3 gezeigte Dichtungselement mit der sie haltenden Leiste 3 bzw. Klemmleiste 26 usw. an der Türinnenfläche über vorzugsweise vier Seiten umlaufend ausgebildet ist. Im aufgeblasenen Zustand des Dichtungselements 17 liegt die Dichtungsoberfläche 27 über einen vorbestimmten Bereich direkt an der Anschlagleiste 5 an. Um einen sehr hohen luftdichten Verschluss zu erzeugen, ist das Dichtungselement 17 zumindest im Bereich der Dichtungsoberfläche 27 profiliert ausgebildet, d.h. mit vorzugsweise in Axialrichtung des Dichtungselements 17 verlaufenden Lippen oder Rippen, wie dies im Detail in Fig. 4 angedeutet ist, versehen.

Im aufgeblasenen Zustand des Dichtungselements 17 drückt daher der mittige Bereich der Dichtungsoberfläche 27 gegen die Anschlagleiste 5, wohingegen die Kontaktfedern 28, 29 an ihren hakenförmigen oder kreisförmigen Enden umgebogen zwischen der Dichtungsoberfläche 27 und der Fläche der Anschlagleiste 5 klemmend zum Liegen kommen und einen elektrischen Kontakt zwischen der Leiste 3 bzw. Klemmleiste 30 einerseits und der Anschlagleiste 5 andererseits hervorrufen. Dadurch, dass die Leiste 3 mit der restlichen, aus Metall bestehenden Türkonstruktion 2 bei 35, 36 verschweißt sind, ergibt sich über die gesamte Breite des in Fig. 2 gezeigten Tores eine Abschirmwirkung, welche über die Kontaktfedern 28, 29 bis hin zur Gebäudewandung mit dem dort vorhergesehen Gewebe 19, 20 wirksam ist, d.h. über die Gebäudeöffnung hinweg um das gesamte Gebäude herum.

Um gegenüber einem Angriff von außen keine Schwachstelle zu bieten, ist die in Fig. 3 gezeigte Anordnung so in das Tor integriert, dass das Dichtungselement 17 mit der Klemmleiste 26 zur Türmitte hin ausgebildet ist, d.h. von der Torschmalseite bzw. Torkante her jeweils die Leiste 3 mit der darüberliegenden Klemmleiste 30 nach außen weisend vorgesehen ist. Wie Fig. 2 zeigt, ist der Einbaurahmen 4 elektrisch mit dem Gewebe 19 im Bereich des Gewebeendabschnitts 19a verbunden. Die Anschlagleiste 5 ist vorzugsweise mit dem Einbaurahmen 4 verschweißt, so dass zwischen dem Gewebe 19 und der Anschlagleiste 5 ein guter elektrischer Kontakt existiert.

Die in Fig. 3 gezeigte Darstellung eignet sich vorteilhafterweise zum Einsatz bei einer Drehtür.

Fig. 4 zeigt eine gegenüber Fig. 3 abgewandelte Ausführungsform eines Tores mit Dichtungselement 17. Entsprechend Fig. 3 ist das Dichtungselement im nicht-aufgeblähten bzw. nicht aufgeblasenen Zustand wie auch im aufgeblasenen Zustand dargestellt, wobei im Fig.3 im aufgeblasenen Zustand die an der Dichtungsoberfläche 27 ausgebildeten Lippen oder Rippen nicht dargestellt sind. Im Prinzip entspricht die Ausgestaltung nach Fig. 4 derjenigen, wie sie in Verbindung mit Fig. 3 beschrieben ist. Unterschiedlich zu Fig. 3 ist, dass das Dichtungselement 17 zwei seitlich verlängerte Fußabschnitte 24a, 24b aufweist, die sich gegenüber der Ausführungsform nach Fig. 3 von der Basis 24 über eine größere Distanz nach außen erstrecken. Die Fußabschnitte 24a, 24b haben bei der Ausführungsform nach Fig. 3 eine kleinere Höhe, jedoch eine größere Schenkellänge bzw. größere Breite und werden durch Klemmleisten 38, 39 gegenüber der Leiste 3 eingespannt.

Um die Klemmleisten 38, 39 gegenüber der Leiste 3 zu befestigen, sind Schraubmittel 41, 42 oder dergleichen vorgesehen, welche durch die Klemmleisten 38, 39 hindurchgehen und in entsprechende Gewinde in der Leiste 3 greifen. Die Kontaktfedern 28, 29 befinden sich im nicht-aufgeblasenen Zustand des Dichtungselements 17 nahezu in einer Ebene, welche durch die obere Fläche der Leiste 3 bzw. durch die Klemmleisten 30, 31 definiert ist, wobei die hakenförmigen oder abgerundeten Enden der Kontaktfedern 28, 29 innerhalb des eingefalteten Bauchs des Dichtungselements 17 liegen, d.h. sie stehen, wenn überhaupt nur geringfügig über das Dichtungselement 17 in deren nicht aufgeblasenen Zustand vor, um bei der Verlagerung eines Schiebetors während des Schiebevorgangs nicht oder nicht zu weit aus dem Tor heraus vorzustehen. Auf diese Weise werden Beschädigungen an den Kontaktfedern vermieden.

Im aufgeblasenen Zustand des Dichtungselements 17 und bei geschlossenem Tor drückt die Dichtung die Kontaktfedern 28, 29 mit deren abgebogenen Enden gegen die Anschlagleiste 5. Fig. 4 ist eine schematische Darstellung in einem Zustand, in dem die Dichtung noch nicht vollständig aufgeblasen ist. Im vollständig aufgeblasenen Zustand wird ein luftdichter Verschluss zwischen dem Dichtungselements 17 und der Anschlagleiste 5 hervorgerufen, wie dies in Verbindung mit Fig. 3 beschrieben und erläutert ist. Im vollständig aufgeblasenen Zustand liegen damit die in Fig. 4 durch das Bezugszeichen 45 angedeuteten Lippen oder Rippen zumindest teilweise vollflächig an der Oberfläche der Anschlagleiste 5 an, und zwar in dem Zwischenraum, der zwischen den umgebogenen Enden der Kontaktfedern 28, 29 für das Dichtungselement 17 zur Verfügung steht.

Die Klemmleisten 38, 39 liegen nach Fig. 4 zusammen mit dem Dichtungselement 17 in einem etwa U-förmig ausgesparten Bereich 46 der Leiste 3, d.h. innerhalb einer Nut, deren Breite der Gesamtbreite aus Dichtung und Klemmleisten 38, 39 entspricht. Bei dieser Ausführungsform können die Klemmleisten 38, 39 in geringem Abstand zu den seitlichen Schenkeln der U-förmigen Aussparung 46 angeordnet sein, ohne dass dadurch die Funktionsfähigkeit des Dichtungselements 17 beeinträchtigt wird. Die Kontaktfedern 28, 29 reichen von der Nut 7a, 7b, in welche ein elektrisch leitfähiges Gewebe 8a, 8b eingesetzt ist, bis etwa in Richtung Mitte des Dichtungselements 17 und überdecken dabei die Klemmleisten 38, 39, bevor die Kontaktfedern 28, 29 in die hakenförmigen bzw. kreisförmigen Endabschnitte übergehen.

Die Leiste 3 ist, wie in Bezug auf die Ausführungsform nach Fig. 3 beschrieben, mit der übrigen Türkonstruktion 2 fest verbunden, vorzugsweise verschweißt.

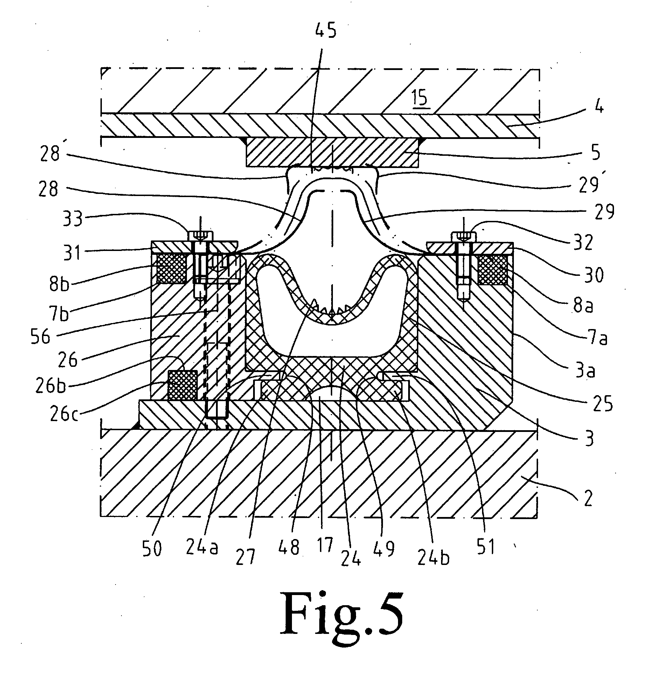

Fig. 5 zeigt eine weitere Variante eines Tors mit einem pneumatischen Dichtungselement, vorzugsweise zur Verwendung bei einem Drehtor in Teilschnittansicht. Diese Ausführungsform dient vorzugsweise zum Einsatz bei einem Drehtor. Wie in der in Fig. 5 gezeigten Ausführungsform gezeigt verläuft das Dichtungselement 17 vorzugsweise ebenfalls umlaufend an der Torinnenfläche. Gleiche Teile gegenüber Fig. 3 und Fig. 4 sind mit gleichen Bezugszeichen versehen und werden hier nicht nochmals erläutert.

Die Ausführungsform nach Fig. 5 ist im Prinzip ähnlich der Ausführungsform nach Fig. 3, d.h. das Dichtungselement 17 wird durch die umgebenden Wandbereiche eingefasst. Das Dichtungselement 17 ist nach Fig. 5 mit Fußabschnitten 24a, 24b versehen, die gegenüber dem nach oben in Fig. 5 sich erstreckenden Dichtungskörper 25 beabstandet sind, d.h. zwischen dem Fußabschnitt 24a, 24b und dem Dichtungskörper 25 befindet sich ein in Axialrichtung des Dichtungselements 17 verlaufender Schlitz 48, 49 mit einer vorgegebenen Schlitzbreite. In diese Schlitze 48, 49 greifen Rippen 50, 51 ein. Die Rippe 51 ist als von der Leiste 3 abstrebender Vorsprung vorgesehen, während die Rippe 50 als von der Klemmleiste 26 abstrebender Vorsprung ausgebildet ist. Die Rippen 50, 51 erstrecken sich in einer Ebene parallel zur Türkonstruktion 2.

Bei der Ausführungsform nach Fig. 5 wird damit im Wesentlichen das Prinzip nach Fig. 3 angewandt, d.h. das Dichtungselement 17 ist durch die Leiste 3 einerseits und die Klemmleiste 26 andererseits fixiert, indem entsprechende Vorsprünge die Fußabschnitte 24a, 24b haltern. Fig. 5 zeigt zum Einen den Zustand des nicht-aufgeblasenen Dichtungselements 17 und im gestrichelten Zustand das aufgeblasene Dichtungselement. Im aufgeblasenen Zustand drückt die Dichtungsoberfläche 27 mit Rippen bzw. Rillen 45 fest gegen die Anschlagleiste 5 und bewirkt damit einen luftdichten Verschluss. Gleichzeitig drückt das Dichtungselement 17 die Kontaktfedern 28, 29 nach oben in einen elektrischen Kontakt mit der Anschlagleiste 5. Die Befestigung der Kontaktfedern 28, 29 entspricht der in Verbindung mit Fig. 3 beschriebenen Art, d.h. sie stehen mit einem metallisch leitenden Gewebe 8a, 8b in elektrischem Kontakt und sind durch Klemmleisten 30, 31 gegenüber der Leiste 3 bzw. Klemmleiste 26 befestigt. Das von der Lippe des Dichtungselementes 17 entfernte Ende jeder Kontaktfeder 28, 29 ist entsprechend den Ausführungsformen nach Fig. 3 und 4 direkt in das Gewebe 8a, 8b eingeleitet bzw. eingesetzt oder durchdringt das Gewebe 8a, 8b zumindest teilweise, wodurch ein ausgezeichneter elektrischer Kontakt zwischen Letzteren sichergestellt ist.

Die Klemmleiste 26 wird entsprechend der Ausführungsform nach Fig. 3 gegenüber der Leiste 3 durch Schraubmittel 56 befestigt und auch bei dieser Anordnung, vorzugsweise benutzt für den Einsatz an einem Drehtor gilt, dass die mit 3a bezeichnete Außenfläche zur Türaußenkante weist, während die Klemmleiste 26 zur Türmitte hin, angeordnet ist. Das Gewebe in der Nut 26b ist mit 26c bezeichnet und bewirkt entsprechend der Ausführungsformen nach Fig. 3 einen elektrischen Kontakt zwischen der Klemmleiste 26 einerseits und der Leiste 3 andererseits.

Bei der in Fig. 5 gezeigten Ausführungsform ist die Basis 24 des Dichtungselements 17 an der nach unten weisenden Fläche in Axialrichtung bogenförmig gestaltet, wodurch gegenüber der Ausführungsform nach Fig. 3 Material eingespart wird. Die Basis 24 kann aber auch entsprechend Fig. 3 als im Wesentlichen rechteckiges Element ausgebildet sein. Wesentlich ist, dass die Rippen 50, 51 das Dichtungselement 17 durch deren Schlitze 48, 49 erfasst und fest in ihrer Position halten. Der Einbau des Dichtungselements 17 erfolgt derart, dass das Dichtungselement 17 entsprechend der Ausführungsform nach Fig. 3 auf die Leiste 3 aufgesetzt und soweit an die Leiste 3 angesetzt wird, dass die Nase oder Rippe 51 in die seitliche schlitzförmige Aussparung 49 eingeführt wird, wonach dann die Klemmleiste 26 entsprechend seitlich auf das Dichtungselement 17 zubewegt wird, bis der Schlitz 48 in die Aussparung 50 eingreift. Anschließend wird die Klemmleiste 26 durch die Schraubmittel 56 an der Leiste 3 befestigt. Schließlich werden die Kontaktfedern 28, 29 mittels der Klemmleisten 30, 31 in der in Fig. 5 gezeigten Weise an der Klemmleiste 26 bzw. Leiste 3 durch Schraubmittel 33 bzw. 32 befestigt.

Die Erfindung bezieht sich auf Drehtüren, Schiebetore und Drehtore mit pneumatischen Dichtungen. Tore dieser Art haben ein Gewicht zwischen 150 und 400 Tonnen. Entsprechend sind die Dichtungselemente 17 größenmäßig ausgelegt, die mit einem Dichtungsdruck zwischen 0,1 bis 0,5 bar beschickt werden. Die Dichtungselemente 17 haben eine Höhe von ca. 20 bis 50 mm und eine Breite von etwa 50 mm bei Toren dieser Art, können aber hinsichtlich ihrer Abmessungen entsprechend verändert werden.

Die bei den vorstehend beschriebenen Dichtungsanordnungen verwendeten Kontaktfedern haben einen parallel zu den Klemmleisten 30, 31 verlaufenden durchgängigen Abschnitt, an den sich die Federzungen in Richtung auf den Dichtungskörper 25 anschließen. Die Federzungen haben vorzugsweise eine Breite von 6 mm, d.h. zwischen benachbarten Federzungen befinden sich Schlitze mit einer Schlitzbreite von beispielsweise 1 mm.

Die in den Dichtungsanordnungen verwendeten Gewebestricken bestehen vorzugsweise aus Kupfer. Bevorzugt werden EMV-Dichtungen in Form von Gewebestricken mit Abmessungen von 10 x 10 mm verwendet.

Das Material der Kontaktfedern besteht vorzugsweise aus CuBr.

Bei den Ausführungsformen nach Fig. 3 und 5 ist die Aufnahmeleiste 3 für das Dichtungselement 17 seitlich im Wesentlichen L-förmig ausgespart zur Aufnahme des Dichtungselements 17 und der Klemmleiste 26, wobei die Klemmleiste 26 diese Aussparung seitlich und gegenüber der Leiste 3 abschließt.

Bei den vorstehend beschriebenen Ausführungsformen sind die Kontaktfedern 28, 29 von zwei Seiten in Richtung auf die Mitte des Dichtungselements 17 verlaufend vorgesehen. Vorzugsweise enden die hakenförmigen Endabschnitte der Kontaktfedern 28, 29 nicht nur in Abstand zueinander, sondern auch in einem Abstand zur Mittellinie des Dichtungselements 17, um ein definiertes Aufstellen der Kontaktfederenden in Richtung auf die Anschlagleiste 5 sicherzustellen, d.h. es soll zwischen den aufgestellten Kontaktfederenden im aufgeblasenen Zustand des Dichtungselements 17 ein solcher Abstand verbleiben, dass sich das Dichtungselement 17 mit ihrer Oberfläche 27 luftdicht an die zugehörige Fläche der Anschlagleiste 5 anpressen kann.

Aus vorstehenden Ausführungen ist ersichtlich, dass sowohl das Dichtungselement 17 als auch die oberhalb des Dichtungselements 17 befindlichen elektrischen Kontaktfedern 28, 29 an der Torinnenfläche vorzugsweise komplett umlaufend ausgebildet sind.

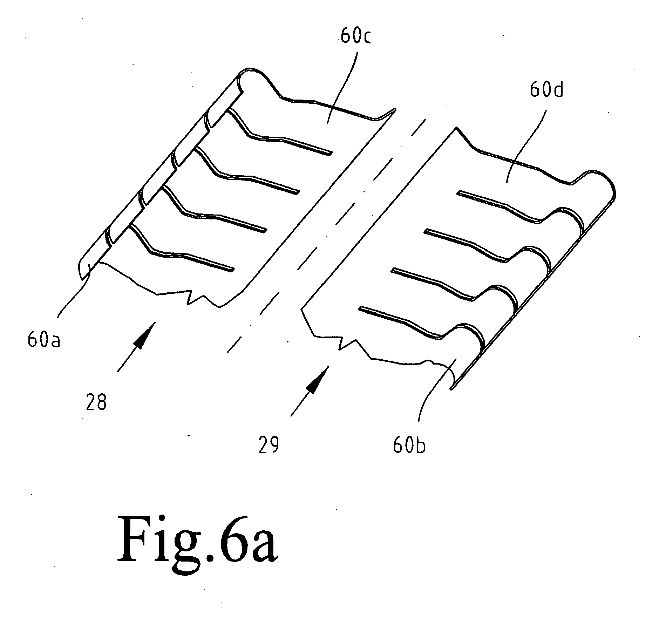

Die Fig. 6a bis 6c zeigen Beispiele für Kontaktfedern 28, 29, die über einen ersten Bereich, der mit 60c und 60d bezeichnet ist, schlitzfrei sind, während im Bereich der Kontaktfederenden, die mit 60a und 60b bezeichnet sind, geschlitzt sind. Die Schlitzbreite, die bei einer bevorzugten Ausführungsform 1 mm beträgt, hängt von der Frequenz der abzuschirmenden elektromagnetischen Wellen und/oder Impulse ab und wird im Bedarfsfall entsprechend geändert. Die Breite der durch die Schlitze definierten Federzungen beträgt dabei vorzugsweise 5 mm.

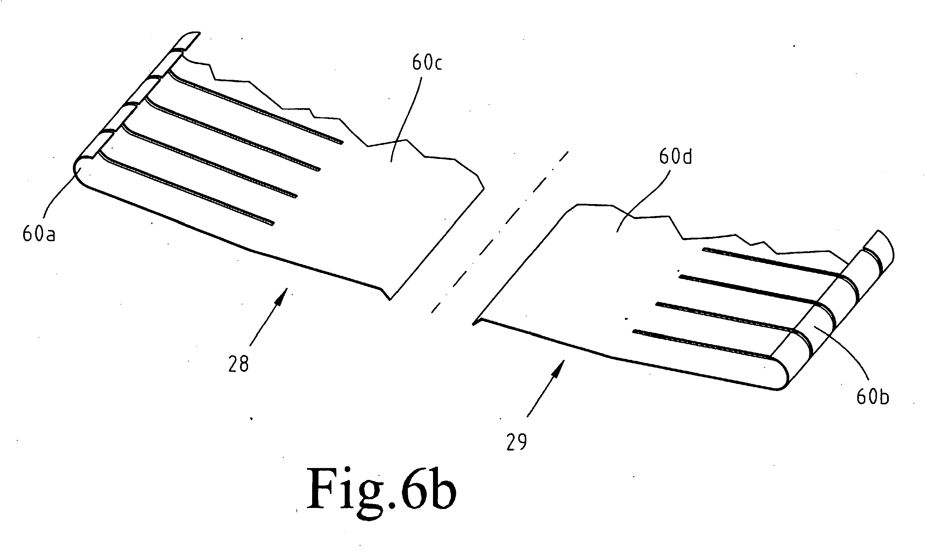

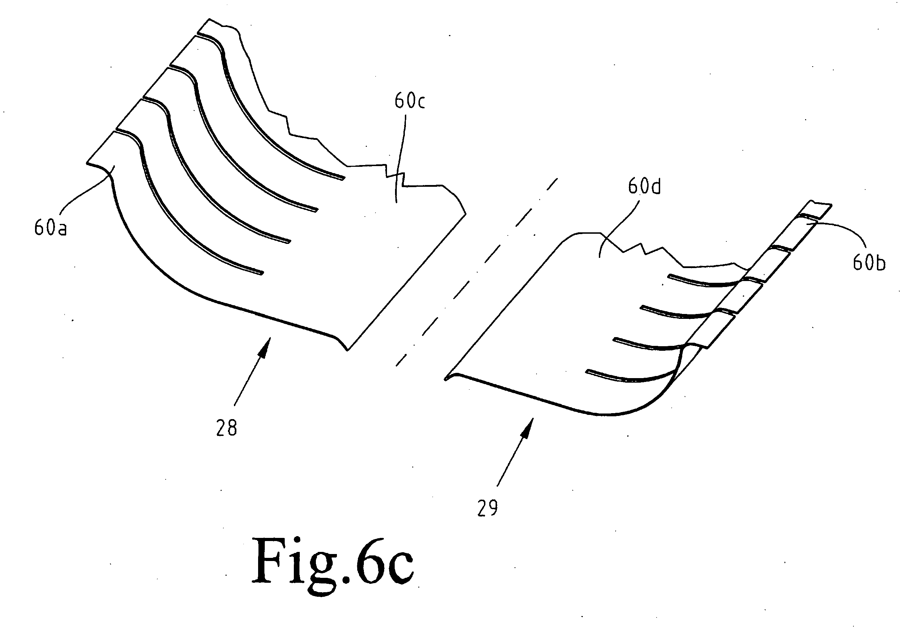

Fig. 6a zeigt ein Kontaktfederpaar 28, 29, das sich vorzugsweise zum Einsatz bei einer Drehtür mit Dichtung nach Fig. 3 eignet, Fig. 6b veranschaulicht ein Federpaar, welches vorzugsweise verwendet wird bei einem Schiebetor mit einer Dichtung gemäß Fig. 4, während Fig. 6c ein Federpaar veranschaulicht, welches vorzugsweise bei einem Drehtor mit Dichtung entsprechend Fig. 5 verwendet wird. Gleiche Bezugszeichen geben dabei gleiche Teile an.

## Patentansprüche

1. Pneumatische Dichtung für Türen oder Tore, insbesondere Dreh- oder Schiebetore und Drehtüren,
wobei die Dichtung eine Leiste (3) beinhaltet, die ein pneumatisch betätigbares Dichtungselement (17) aufnimmt, **dadurch**
**gekennzeichnet, dass**
in der Leiste (3) beidseitig des Dichtungselementes (17) Nuten (7a, 7b) ausgebildet sind, die ein elektrisch leitendes Gewebe (8a, 8b) aufnehmen, dass beidseitig des Dichtungselements (17) Klemmleisten (30, 31) angeordnet sind, die jeweils eine Kontaktfeder (28, 29) befestigen, wobei die Kontaktfedern (28, 29) jeweils hakenförmige oder kreisbogenförmige Enden aufweisen, und
wobei diese hakenförmigen oder kreisbogenförmigen Enden der beiden Kontaktfedern (28, 29) zueinander beabstandet sind und das Dichtungselement (17) teilweise überdecken.

2. Dichtung nach Anspruch 1,
**dadurch gekennzeichnet,**
**dass** das Dichtungselement (17) Fußabschnitte (24a, 24b) aufweist und dass jede Leiste (3) mit Sockelabschnitten versehen ist, welche die Fußabschnitte (24a, 24b) übergreifen.

3. Dichtung nach Anspruch 1,
**dadurch gekennzeichnet,**
**dass** das Dichtungselement (17) eine Basis (24) sowie etwa parallel zur Basis (24) verlaufende Schlitze (48, 49) aufweist, und dass die Leiste (3) mit Rippen (50, 51) versehen ist, welche in die Schlitze (48, 49) eingreifen.

4. Dichtung nach Anspruch 1,
**dadurch gekennzeichnet,**
**dass** die Leiste (3) Fußabschnitte (24a, 24b) aufweist, und
**dass** an der Leiste (3) durch Schraubmittel (41, 42) befestigte weitere Klemmleisten (38, 39) vorgesehen sind, welche die Fußabschnitte (24a, 24b) des Dichtungselementes (17) halten.

5. Tür oder Tor zum Verschließen einer Gebäudeöffnung (14), mit einer Tür- bzw. Torplatte (2), mit einem gebäudeseitig angebrachten, elektrisch leitenden Einbaurahmen (4) aus Metall, mit einer zumindest teilweise umlaufenden pneumatischen Dichtung nach einem der vorangehenden Ansprüche zur luftdichten Anlage an dem Einbaurahmen (4), **dadurch gekennzeichnet,**
**dass** sich die Kontaktfedern (28, 29) in Richtung auf die Längsachse des Dichtungselementes (17) und mit ihrem Ende oberhalb der zur Gebäudeöffnung (14) weisenden Dichtungsoberfläche (27) des Dichtungselementes (17) erstrecken, derart, dass die Kontaktfedern (28, 29) bei geschlossener Tür/Tor in einen elektrischen Kontakt mit dem Einbaurahmen (4) gepresst werden und zugleich die Dichtungsoberfläche (27) des Dichtungselementes (17) in einem luftdichten Kontakt gegenüber dem Einbaurahmen (4) steht.

6. Tür oder Tor nach Anspruch 5, **dadurch gekennzeichnet, dass** die Leiste (3) eine weitere Klemmleiste (26) aufweist, die auf einer L-förmigen Aussparung der Leiste (3) unter Einfassung des Dichtungselementes (17) befestigt ist.

7. Tür oder Tor nach Anspruch 5, **dadurch gekennzeichnet, dass** die Leiste (3) eine im Wesentlichen U-förmigen Nut (46) aufweist, in welche das Dichtungselement (17) unter Einfassung durch weitere Klemmleisten (38, 39) eingesetzt ist.

8. Tür oder Tor nach Anspruch 6, **dadurch gekennzeichnet, dass** die Leiste (3) und die weitere Klemmleiste (26) mit in ihre Oberfläche eingeschnittenen Nuten (7a, 7b) versehen sind, wobei die Nuten (7a, 7b) das elektrisch leitfähiges Gewebe (8a, 8b) aufnehmen, in welches Enden der Kontaktfedern (28, 29) eingepresst sind.

9. Tür oder Tor nach Anspruch 8,
**dadurch gekennzeichnet,**
**dass** die Nuten (7a, 7b) durch die Klemmleisten (30, 31) unter Einschluss der Kontaktfedern (28, 29) abgedeckt sind.

10. Tür oder Tor nach Anspruch 5, **dadurch gekennzeichnet, dass** die Kontaktfedern (28, 29) aus einem nicht unterbrochenen Streifen bestehen, der im Wesentlichen unterhalb der Klemmleisten (30, 31) verläuft, und wobei die Kontaktfedern (28, 29) Zungen aufweisen, die oberhalb des Dichtungselementes (17) angeordnet und mit Schlitzen versehen sind.

11. Tür oder Tor nach Anspruch 5,
**dadurch gekennzeichnet,**
**dass** die Kontaktfedern (28, 29) zumindest teilweise quer zur Längsachse des Dichtungselementes (17) geschlitzt sind.

## Claims

1. Pneumatic seal for doors or gates, in particular revolving or sliding gates and revolving doors, the seal containing a strip (3) which receives a pneumatically actuatable sealing member (17), **characterised in that** grooves (7a, 7b) are formed in the strip (3) on either side of the sealing member (17) and receive an electrically conductive fabric (8a, 8b), and **in that** clamping strips (30, 31) are arranged on either side of the sealing member (17) and each fix a contact spring (28, 29), the contact springs (28, 29) each having hook-shaped or circular arc-shaped ends, and these hook-shaped or circular arc-shaped ends of the two contact springs (28, 29) being at a distance from one another and covering the sealing member (17) in part.

2. Seal according to claim 1, **characterised in that** the sealing member (17) has foot portions (24a, 24b), and **in that** each strip (3) is provided with stand portions which the foot portions (24a, 24b) overlap.

3. Seal according to claim 1, **characterised in that** the sealing member (17) has a base (24) and slots (48, 49) which extend approximately parallel to the base (24), and **in that** the strip (3) is provided with ribs (50, 51) which engage in the slots (48, 49).

4. Seal according to claim 1, **characterised in that** the strip (3) has foot portions (24a, 24b), and **in that** further clamping strips (38, 39) are provided which are fixed to the strip (3) by screw means (41, 42) and hold the foot portions (24a, 24b) of the sealing member (17).

5. Door or gate for closing a building opening (14), comprising a door or gate panel (2), comprising a metal installation frame (4) which is attached on the building side and is electrically conductive, further comprising a pneumatic, at least partly circumferential seal according to any one of the preceding claims for airtight abutment against the installation frame (4), **characterised in that** the contact springs (28, 29) extend in the direction of the longitudinal axis of the sealing member (17) and with their end above the seal surface (27) of the sealing member (17), said surface (27) facing to the building opening (14), in such a way that when the door/gate is closed, the contact springs (27, 28) are pressed into electrical contact with the installation frame (4) and, at the same time, the seal surface (27) of the sealing member (17) is in air-tight contact with the installation frame (4).

6. Door or gate according to claim 5, **characterised in that** the strip (3) comprises a further clamping strip (26) which is fixed on an L-shaped recess in the strip (3) while enclosing the sealing member (17).

7. Door or gate according to claim 5, **characterised in that** the strip (3) has a substantially U-shaped groove (46) into which the sealing member (17) is inserted while being enclosed by further clamping strips (38, 39).

8. Door or gate according to claim 6, **characterised in that** the strip (3) and the further clamping strip (26) are provided with grooves (7a, 7b) cut into the surface thereof, the grooves (7a, 7b) receiving the electrically conductive fabric (8a, 8b) into which ends of the contact springs (28, 29) are pressed.

9. Door or gate according to claim 8, **characterised in that** the grooves (7a, 7b) are covered by the clamping strips (30, 31) while also encompassing the contact springs (28, 29).

10. Door or gate according to claim 5, **characterised in that** the contact springs (28, 29) consist of a continuous strip extending substantially below the clamping strips (30, 31), the contact springs (28, 29) having tongues which are arranged above the sealing member (17) and are provided with slots.

11. Door or gate according to claim 5, **characterised in that** the contact springs (28, 29) are slotted, at least in part, transversely to the longitudinal axis of the sealing member (17).

## Revendications

1. Joint d'étanchéité pneumatique pour portes, en particulier pour portes battantes ou coulissantes,
- le joint comprenant une réglette (3) qui loge un élément d'étanchéité actionnable pneumatiquement (17), **caractérisé par le fait que** des rainures (7a, 7b) sont formées dans la réglette (3) des deux côtés de l'élément d'étanchéité (17) qui reçoivent un tissu (8a, 8b) électroconducteur, des bomiers (30, 31) sont disposés des deux côtés de l'élément d'étanchéité (17), fixant chacun un ressort de contact (28, 29), les ressorts de contact (28, 29) présentant chacun des extrémités en forme de crochet ou en forme d'arc circulaire, et
- les extrémités en forme de crochet ou en forme d'arc circulaire des deux ressorts de contact (28, 29) étant situées à distance l'une de l'autre et recouvrent partiellement l'élément d'étanchéité (17).

2. Joint selon la revendication 1, **caractérisé par le fait que** l'élément d'étanchéité (17) présente des sections inférieures (24a, 24b) et que chaque réglette (3) est dotée de parties de socle recouvrant les sections inférieures (24a, 24b).

3. Joint selon la revendication 1, **caractérisé par le fait que** l'élément d'étanchéité (17) présente une base (24) ainsi que des rainures (48, 49) s'étendant pratiquement de manière parallèle à la base (24), et que la réglette (3) est dotée de nervures (50, 51) venant en prise avec la rainure (48, 49).

4. Joint selon la revendication 1, **caractérisé par le fait que** la réglette (3) présente des sections inférieures (24a, 24b), et que d'autres bomiers (38, 39) sont fixés sur la réglette (3) par les moyens de vissage (41, 42), qui maintiennent les sections inférieures (24a, 24b) de l'élément d'étanchéité (17).

5. Porte destinée à fermer une ouverture (14) de bâtiment, pourvue d'une plaque de porte (2), d'un cadre d'encastrement (4) en métal électroconducteur placé côté bâtiment, d'un joint périphérique au moins partiellement pneumatique, selon l'une des revendications susmentionnées pour réaliser une installation hermétique sur le cadre d'encastrement (4), **caractérisée par le fait que** les ressorts de contact (28, 29) s'étendent dans le sens de l'axe longitudinal de l'élément d'étanchéité (17) et avec leur extrémité au-dessus de la surface d'étanchéité (27) de l'élément d'étanchéité (17) orientée vers l'ouverture (14) du bâtiment de telle sorte que les ressorts de contact (28, 29) sont comprimés dans un contact électrique avec le cadre d'encastrement (4) lorsque la porte est fermée et simultanément la surface d'étanchéité (27) de l'élément d'étanchéité (17) se trouve en contact hermétique par rapport au cadre d'encastrement (4).

6. Porte selon la revendication 5, **caractérisée par le fait que** la réglette (3) présente un autre bomier (26) fixé sur un évidement en forme de L de la réglette (3) par cerclage de l'élément d'étanchéité (17).

7. Porte selon la revendication 5, **caractérisée par le fait que** la réglette (3) présente une rainure essentiellement en forme de U (46), dans laquelle l'élément d'étanchéité (17) est introduit par cerclage par l'intermédiaire d'autres bomiers (38, 39).

8. Porte selon la revendication 6, **caractérisée par le fait que** la réglette (3) et l'autre bomier (26) sont dotés de rainures (7a, 7b) découpées dans leur surface, les rainures (7a, 7b) recevant le tissu (8a, 8b) électroconducteur, dans lequel des extrémités des ressorts de contact (28, 29) sont insérées par pression.

9. Porte selon la revendication 8, **caractérisée par le fait que** les rainures (7a, 7b) sont recouvertes par les bomiers (30, 31) en incluant les ressorts de contact (28, 29).

10. Porte selon la revendication 5, **caractérisée par le fait que** les ressorts de contact (28, 29) sont constitués d'une bande ininterrompue, qui s'étend essentiellement sous les bomiers (30, 31), et que les ressorts de contact (28, 29) présentant des languettes disposées au-dessus de l'élément d'étanchéité (17) et étant dotés de fentes.

11. Porte selon la revendication 5, **caractérisée par le fait que** les ressorts de contact (28, 29) sont fendus au moins partiellement perpendiculairement à l'axe longitudinal de l'élément d'étanchéité (17).
